# EUROPEAN PATENT APPLICATION

(11) **EP 3 641 136 A1**
(43) Date of publication of application: **22.04.2020**
(21) Application number: 18201473.8
(22) Date of filing: 19.10.2018
(51) Int. Cl.: H03M 3/00

(54) **ANALOG-TO-DIGITAL MULTI-BIT DELTA-SIGMA MODULATOR, METHOD FOR CONVERTING AN ANALOG INPUT SIGNAL INTO A DIGITAL MULTI-BIT OUTPUT SIGNAL, AND ANALOG-TO-DIGITAL CONVERTER**

(71) Applicant: Universität Ulm, 89081 Ulm (DE)
(72) Inventor: Jain, Ankesh, 89075 Ulm (DE); Ortmanns, Maurits, 89075 Ulm (DE)
(74) Representative: Lorenz, Markus

(57) **Abstract**

An analog-to-digital multi-bit delta-sigma modulator (1) comprising a loop filter (2) with a feedback path, a multi-bit quantizer (3) quantizing the output (y[n], y(t)) of the loop filter (2) and generating a digital multi-bit output signal (v[n]), and at least one feedback digital-to-analog converter (4, 5) within the feedback path. A digital-to-analog delta-sigma modulator (6) is additionally provided within the feedback path generating a first feedback signal component (v1[n]) by reducing the word-length of the digital multi-bit output signal (v[n]), wherein the first feedback signal component (v1[n]) is fed into the outermost branch of the loop filter (2) via the at least one feedback digital-to-analog converter (4). The digital-to-analog delta-sigma modulator (6) is designed as multi-stage noise shaping delta-sigma modulator (6) comprising a first stage (6.1) for generating the first feedback signal component (v1[n]), and at least a second stage (6.2) for generating at least one additional feedback signal component (v2[n]). The at least one additional feedback signal component (v2[n]) is also fed into the loop filter (2), wherein the node for feeding-in the at least one additional feedback signal component (v2[n]) is chosen such and the loop filter (2) is designed such that a combination filter for the feedback signal components (v1[n], v2[n]) of the multi-stage noise shaping delta-sigma modulator stages (6.1, 6.2) is realized.

## Description

The invention relates to an analog-to-digital multi-bit delta-sigma modulator comprising a loop filter with a feedback path, a multi-bit quantizer quantizing the output of the loop filter and generating a digital multi-bit output signal, and at least one feedback digital-to-analog converter within the feedback path, according to the generic part of claim 1.

The invention also relates to a method for converting an analog input signal into a digital multi-bit output signal employing an analog-to-digital multi-bit delta-sigma modulator, according to the generic part of claim 13.

The invention further relates to an analog-to-digital converter.

Delta-sigma modulators (DSMs) can be used to convert a real-time analog input signal into a digital output signal, thus to realize a delta-sigma analog-to-digital converter (DS-ADC). Especially for high speed operation they almost exclusively employ an internal multi-bit quantizer. This allows a stable operation with aggressive noise shaping, which is good for high signal-to-quantization-noise ratio (SQNR), and thus low oversampling ratio (OSR), which is advantageous for high signal bandwidth. Employing a multi-bit quantizer also allows large maximum stable input amplitude (MSA), which translates into a larger allowable input referred electronic noise and thus lower power consumption.

However, the multi-bit quantizer also adds nonlinearity due to the multi-bit feedback digital-to-analog converter (DAC), which often limits the overall performance of state of the art multi-bit DSM. In order to improve the performance of the multi-bit DSMs, several techniques for multi-bit DAC linearization are meanwhile known.

For example, large DAC sizing can make the relative mismatch between the unit elements of the DAC smaller. But large elements in the DAC also lead to large parasitic capacitances at the first DSM integrator input (the input of the integrator closest to the input stage of the loop filter), which results in major power consumption in this integrator to achieve its speed requirements.

Apart from this, dynamic element matching (DEM) is often used which either randomly swaps the DAC elements or scrambles them with given sequences. But both techniques have the disadvantage that they need a significant digital circuit overhead as well as a rather large OSR in order to effectively reduce the nonlinearity from the multi-bit DAC.

Other techniques, which measure the DAC nonlinearity and cancel it in the analog or digital domain, are also known. But these techniques usually come with major area and/or power overhead and usually they only correct for static DAC mismatch, but not for dynamic mismatch such as finite and unequal rise and fall times of the DAC output signals, which then leads to intersymbol interference and dynamic nonlinearity.

In order to avoid the problem of a nonlinear feedback DAC completely, it is also known to circumvent the multi-bit quantization itself, i. e., to use a single-bit internal quantizer in the DSM, because this comes with an inherently linear single-bit feedback DAC. This is because single-bit DACs exhibit two output data points only, which can always be connected by a straight line in the transfer function, thus intrinsically linear. This concept can also be exploited for so called 1.5-bit DACs, meaning three output points of the DAC. Disadvantageously, single-bit DSMs show by far worse noise shaping due to loop filter scaling for the sake of stability, and thus lower SQNR for a given filter order and given OSR, which is why they need much higher OSRs for similar performance as their multi-bit counterparts, and they suffer from limited stability and also reduced MSA; the latter dictates reduced input referred circuit noise when the same SNR should be achieved.

Thus, the major state of the art has to either cope with the disadvantages associated with the single-bit approach or with those of the multi-bit approach.

However, in the recent past, few techniques became known that combine a multi-bit quantization with a single-bit feedback DAC, thus trying to combine both advantages.

In the publication H. Pakniat and A. Torralba, "A ΣΔ-FIR-DAC for Multi-Bit ΣΔ Modulators", IEEE Transactions on Circuits and Systems - I: Regular Papers, vol. 60, no. 9, pp. 2321-2332, Sep. 2013, which is considered as prior art closest to the presented invention, the authors have implemented the feedback DAC of an analog-to-digital multi-bit DSM ("main DSM") of a DS-ADC as a digital noise shaping DS-DAC itself, which converts the digital multi-bit feedback signal coming from the multi-bit quantizer of the multi-bit main DSM into a digital single-bit or 1.5-bit feedback signal. This brings back the inherent linearity property of the feedback DAC. However, reducing the word-length of the feedback signal by the DS-DAC contributes additional shaped digital quantization noise to the system, which must be eliminated (cancelled or filtered) before it enters the multi-bit quantizer of the main DSM. This elimination of the additional quantization noise is mandatory to be done because otherwise the additional quantization noise would significantly reduce the performance and also stability properties of the main DSM. In order to reduce the additional quantization noise, an interpolation filter, a digital noise shaper, an additional FIR filter, and the inherent low-pass filtering of the analog DSM have been used.

However, this technique disadvantageously comes with a tradeoff between the choice of the analog DSM loop filter architecture, the number of bits in the multi-bit quantizer of the main DSM and the operating speed of the additional digital noise shaping DS-DAC for requantization in the feedback of the main DSM. On increasing the number of bits (more than three) in the main quantizer or selecting architectures other than a cascade of integrators feedback (CIFB) architecture demands a stricter filtering of the noise or otherwise results in an additional quantization noise at the input of the main quantizer, which affects the stability of the main DSM and reduces its MSA. This is because the noise shaping order in the digital DS-DAC needs to be followed by a loop filter of the main DSM that is able to sufficiently suppress the noise shaped requantization error from the digital DS-DAC. Thus, the DS-DAC cannot have an arbitrarily high order for a given main DSM. Therefore, this architecture needs the digital DS-DAC to operate at twice the speed of the analog main DSM in order to provide sufficient noise shaping.

For further background on the state of the art, the reader is exemplarily referred to the publication US 2009/0128384 A1, which relates to a multi-stage noise shaping DSM. Furthermore, US 5,369,403 A relates generally to delta-sigma data converters with high linearity and low quantization error.

The purpose of this invention is to present an analog-to-digital multi-bit delta-sigma modulator with improved linearity and higher maximum stable amplitude as compared to the state of the art.

It is also a purpose of this invention to present a new method for converting an analog input signal into a digital multi-bit output signal employing an analog-to-digital multi-bit delta-sigma modulator with improved linearity and higher maximum stable amplitude as compared to the state of the art.

In addition, it is also an object of this invention to provide an analog-to-digital converter with high linearity and high maximum stable amplitude.

With regard to the analog-to-digital multi-bit delta-sigma modulator the purpose is fulfilled by the features of claim 1. Relating to the method for converting an analog input signal into a digital multi-bit output signal the purpose is fulfilled by the features of claim 13. In view of the analog-to-digital converter the purpose of this invention is fulfilled by claim 15.

Further embodiments of the invention will be described hereinafter and in the dependent claims.

An analog-to-digital multi-bit DSM according to the invention comprises a loop filter with a feedback path, a multi-bit quantizer quantizing the output of the loop filter and generating a digital multi-bit output signal, and at least one feedback DAC within the feedback path.

The required components, their interaction and the general function of analog-to-digital multi-bit DSMs are well-known in the state of the art and will thus not be described in detail in the following. The basic structure and assembling of the analog-to-digital multi-bit DSM of this invention can be implemented as commonly known in various architectures and embodiments unless otherwise stated below.

For simplification, the "analog-to-digital multi-bit DSM" may also be called "main DSM" in the following.

According to the invention, a digital-to-analog DSM is additionally provided within the feedback path of the main DSM generating a first feedback signal component by reducing the word-length of the digital multi-bit output signal of the main DSM, wherein the first feedback signal component is fed into the outermost branch (outermost feedback loop) of the loop filter of the main DSM via the at least one feedback DAC.

Further according to the invention, the digital-to-analog DSM is designed as multi-stage noise shaping (MASH) DSM comprising a first stage for generating the first feedback signal component, and at least a second stage for generating at least one additional feedback signal component, wherein the at least one additional feedback signal component is also fed into the loop filter. The node for feeding-in the at least one additional feedback signal component is chosen such and the loop filter is designed such that a combination filter for the feedback signal components of the MASH DSM stages is realized.

According to an embodiment, the combination filter for the feedback signal components is realized as purely implicit, partly implicit or explicit combination filter.

Thus, the present invention is not restricted to the realization of an implicit combination filter and one can realize the combination filter partially implicitly and the remaining part of the transfer function explicitly or even completely explicitly.

According to an advantageous embodiment of the invention, the outermost branch is a branch feeding a first integrator closest to an input stage of the loop filter of the main DSM.

Thus, the idea according to the invention is to combine the advantages of a multi-bit main DSM with the advantages of a feedback DAC with low resolution, preferably 1.5-bit but most preferably single-bit resolution. Thereby, multi-bit-properties as superior DSM stability, aggressive noise shaping, low OSR, and large MSA are combined with intrinsic or at least improved linearity of the feedback DAC.

This can be achieved by requantizing the multi-bit data stream of the multi-bit quantizer into a lower word-length, preferably into 1.5-bit or most preferably into single-bit resolution by employing a digital DS-DAC in the outermost feedback loop of the main DSM.

In contrast to the state of the art, the employed DS-DAC is implemented as a MASH DSM DAC, which firstly allows very high, stable loop filter orders, and it also allows employing multi-bit quantization in the higher stages of the MASH DSM DAC. In the presented invention, the recombination of the MASH stages is not directly performed, but can be done at advantageous places of the loop filter of the main DSM itself, preferably at a later stage in the loop filter.

This allows for the outermost feedback branch having a lower word-length, preferably 1.5-bit or most preferably single-bit, while the overall quantization and noise-shaping performance of the digital MASH DSM is higher due to its potentially high order and potential multi-bit quantization in higher MASH stages, which strongly alleviates the problem of additionally inserted requantization noise in the main DSM. Also, the required combination filters of the MASH DSM DAC can thereby be implicitly realized by reusing the existing analog loop filter of the main DSM, or also explicitly or in combination of implicit and explicit real-izations of the recombination filters.

The word-length of the digital output signal of the main DSM, i. e., the resolution of the quantizer of the main DSM, can be 2-bit, 3-bit, 4-bit, 5-bit, 6-bit, 7-bit, or even higher. Preferably, the resolution of the quantizer is 3-bit to 6-bit.

According to an advantageous embodiment of this invention, the at least one additional feedback signal component is fed into an inner node of the loop filter via an additional feedback DAC. The inner node can be a node preceding an integrator or the quantizer.

Preferably, the inner node can be an inner node subsequent to the node, in which the first feedback signal component is fed-in.

This embodiment can be advantageous, because the nonlinearity of the feedback DACs of later branches of the main DSM is usually already sufficiently suppressed by the noise shaping behavior of its loop filter. Thus, the resolution of those feedback DACs, whose linearity is of lesser importance, can be chosen higher than of the first feedback DAC, whose linearity is of highest importance, which is why also the word-length of the at least one additional feedback signal component can be higher than the word-length of the first feedback signal component.

However, according to another embodiment of the invention, the at least one additional feedback signal component is fed into the same node as the first feedback signal component, via an additional filtering feedback DAC. Preferably, the filtering feedback DAC is realized as capacitor feedback DAC.

By implementing the additional feedback DAC as a capacitor DAC, preferably a single-bit capacitor DAC, an implicit high-pass filter, which can become part of a combination filter for the stages of the MASH DSM, can be realized. In this embodiment, an analog, digital, or mixed-signal cancellation filter can be placed upfront the additional feedback DAC.

According to a preferred embodiment of the invention, the feedback DAC feeding the outermost branch and/or the additional filtering feedback DAC is designed as single-bit DAC.

As a single-bit DAC is an inherently linear device, as already mentioned, the benefits of the invention can be most pronounced for these feedback DAC implementations.

However, according to another embodiment of the invention, the word-length of the first feedback signal component is less than the word-length of the at least one additional feedback signal component.

Thus, the problem of nonlinearity or circuit complexity of the first feedback DAC can already be relaxed according to the invention, if the word-lengths of the feedback signal components are distributed such that the first feedback DAC is fed by the feedback signal component with lowest resolution, which could then also be larger than 1-bit.

In a preferred embodiment of the invention, the first feedback signal component consists of a word-length of one or 1.5-bit

Thus, the truncation in the first stage of the digital MASH DSM and the feedback signal fed through the outermost feedback DAC will improve the linearity of the main DSM.

In another embodiment of the invention, the multi-stage noise shaping delta-sigma modulator consists of two stages, wherein the second stage comprises a single-bit or multi-bit quantizer.

Although the digital MASH DSM can preferably be implemented as two-stage MASH DSM, e. g., with single-bit quantization in each stage or single-bit quantization in the first stage and multi-bit quantization in the second stage, in general the MASH DSM can also be implemented by a three-stage design, four-stage design or with even more stages.

The first stage of the digital MASH DSM can preferably employ a single-bit quantizer. But as mentioned, also the later stages of the MASH DSM can employ single-bit quantization, but preferably employ multi-bit quantization. In general, it can be advantageous to employ a quantizer resolution of the first stage of the MASH DSM which is smaller than the quantizer resolution of the later stages of the digital MASH DSM.

According to an embodiment of the invention, the noise shaping order of the MASH DSM is lower, equal or higher than the noise shaping order of the loop filter of the main DSM. However, the noise shaping order of the MASH DSM can also be smaller than the noise shaping order of the loop filter of the main DSM.

Possible noise shaping orders of the loop filter of the main DSM and/or the MASH DSM can be first order, second order, third order, fourth order or even higher orders. Preferably a first to fourth order, particularly preferred a third order loop filter can be implemented for the main DSM.

The MASH DSM can preferably be implemented with noise shaping DSMs in every stage.

Alternatively, the MASH DSM can also employ zero-order noise shaping in the first, the second and/or in potential higher stages. For example, the "Leslie-Singh" structure (X-0 MASH), c. f., T. C. Leslie, B. Singh, "An Improved Sigma-Delta Modulator Architecture", Proc. IEEE Int. Symp. Circuits and Systems (ISCAS'90), vol. 1, pp. 372-375, 1990-May-1, or a 0-X MASH can be applied. Note, even though the term "MASH" refers to multi-stage noise shaping, the term MASH is also used in the literature and also here for those X-0 or 0-X architectures, where 0-th order stands for a non-noise shaping ADC and X-th order stands for X-th order noise shaping.

According to a further embodiment of the invention, the loop filter is implemented as continuous-time (CT), discrete-time (DT) or hybrid loop filter.

It is an advantage of this invention that the architecture of the main DSM is not restricted to a specific implementation. Thus, the invention can be adopted to be applied for various DSM types. In particular, the main DSM loop filter could be realized with CT filters for high speed applications.

In case the loop filter is realized in CT fashion, the digital MASH DSM can be slightly oversampled in regards of the main DSM, in order to have the recombination filter being implicitly realized by the preceding CT loop filter, which can improve the proper recombination of the MASH DSM stages. For example, an oversampling of a factor of two (or higher) can be used.

In another preferred embodiment of the invention, the feedback signal components of the MASH DSM are injected into the loop filter using at least one mixed-signal finite impulse response (FIR) feedback DAC.

Thus, a MASH DSM FIR DAC employing implicit analog cancellation filtering can be provided.

This embodiment can be advantageous, because using a single-bit feedback DAC in the outermost feedback path of a (CT) DSM comes with two disadvantages. Firstly, the strong single-bit feedback signal component demands large dynamics from the first integrator, which translates into increased power consumption. Secondly, the DSM might become prone to clock jitter, meaning uncertainties in the precision of the sampling clock. Thereby high-frequency quantization noise of the DSM is folded into the in-band by the jittered clock, which deteriorates the performance of the main DSM.

In order to prevent the deterioration of the main DSM's performance, a FIR filter can be employed in the outermost single-bit feedback DAC, which reduces the out-of-band quantization noise before it is mixed with the jittered clock. Therefore, the outermost feedback driven by the first stage of the digital MASH DSM can beneficially be followed by a FIR filter and a reconstruction filter can be implemented at an inner loop to restore the original noise transfer function (NTF), i. e., to compensate for the FIR DAC.

In the presented invention, the first feedback signal component of the digital MASH DSM is fed into the outermost loop for superior linearity, so a FIR filter can be added in this branch for jitter insensitivity. The second stage (at least one additional feedback signal component) of the digital MASH DSM can be fed into a later node of the loop filter, where it can also be filtered by a FIR filter of same type. The same FIR filter can preferably be used as the multi-bit MASH DSM output is supposed to eliminate the single-bit MASH DSM output's quantization noise, so the two paths need some matching.

Advantageously, this FIR filter is effectively seen by the complete digital MASH feedback DAC, and also eliminates major parts of the additionally inserted, remaining out-of-band requantization noise from the digital MASH DSM, which enhances stability, MSA, and internal swing.

The invention also relates to a method for converting an analog input signal into a digital multi-bit output signal employing an analog-to-digital multi-bit DSM ("main DSM") comprising a loop filter, a multi-bit quantizer, and at least one feedback DAC within the feedback path. According to this method, the quantizer quantizes the output of the loop filter and generates the digital multi-bit output signal, wherein a digital-to-analog DSM is additionally employed within the feedback path which generates a first feedback signal component by reducing the word-length of the digital multi-bit output signal. The first feedback signal component is fed into the outermost branch of the loop filter via the at least one feedback DAC.

According to the method of this invention, the digital-to-analog DSM is designed as MASH DSM comprising a first stage generating the first feedback signal component, and a at least a second stage generating at least one additional feedback signal component, wherein the at least one additional feedback signal component is also fed into the loop filter, and wherein the node for feeding-in the at least one additional feedback signal component is chosen such and the loop filter is designed such that a combination filter for the feedback signal components of the MASH DSM is realized.

The combination filter for the feedback signal components can be realized as purely implicit, partly implicit or explicit combination filter.

The method can be used for reducing the resolution of the feedback DAC within a main DSM employing multi-bit internal quantization to realize an ADC. Therefore, in a first step, the DAC in the outermost feedback loop in the main DSM can be selected, wherein after a digital MASH DSM can be employed in that outermost feedback loop with a truncation to a lower number of bits in the first stage. Moreover, the output of the higher stages of the MASH DSM can be injected into inner nodes of the main DSM. The part of the loop filter of the main DSM prior to the injection node of the higher stages of the MASH DSM can implicitly realize the recombination filter of the MASH DSM. The recombination filter can also be partly or fully explicitly realized.

The output bit-width (word-length) of the second or higher stages of the MASH DSM can be smaller, equal, or higher than the bit-width of the quantizer in the main DSM.

In a preferred configuration, the order of the loop filter of the main DSM is three, whereas the MASH DSM has a first stage with an order of two and a second stage with an order of two, and wherein the output of the second stage is inserted after the second integrator in the loop filter of the main DSM.

Summarizing, the proposed main DSM uses a multi-bit MASH based DSM for requantization of multi-bit feedback data (digital multi-bit output signal of the main DSM), wherein the output of the first MASH stage is preferably single-bit and used for the outermost feedback DAC for intrinsic linearity.

The outermost feedback DAC can preferably be designed as FIR DAC for low jitter sensitivity. In addition, by employing a FIR-filter, speed constraints on the first integrator can be reduced, as well as the high-frequency digital quantization noise from the digital MASH DSM be partly filtered.

The output of the successive multi-bit MASH stages can be fed back to internal sections of the loop filter through additional (FIR) DACs. The successive stages of MASH based DSM DAC can be designed in a (nonlinear) multi-bit fashion because their output is fed back into inner nodes of the loop filter where linearity requirements of the corresponding feedback DAC are relaxed. Hence, additional noise added in the main DSM is of multi-bit in nature and might additionally be filtered by a FIR DAC, thereby having minimal impact on in-band noise, MSA and stability of the main DSM.

The recombination filters for the MASH stages can be advantageously implemented as implicit filters by the available loop filter of the main DSM.

The invention can preferably be applied for main DSMs with low OSR, since the most other feedback DAC linearization techniques cannot efficiently be used for small OSRs and potential mismatch issues of the digital MASH DSM and its analog recombination filter, i. e., the implicit analog loop filter of the main DSM, leading to noise leakage, will be alleviated for low OSRs.

The main DSM according to the invention can, e. g., be employed in radio receivers, for audio digitization, for sensor readouts, and many other applications.

According to an embodiment of the invention, the MASH DSM is operated at a higher sampling frequency than the main DSM, preferably at two times the sampling frequency of the main DSM.

The invention also relates to an analog-to-digital converter (ADC) employing an analog-to-digital multi-bit DSM according to the foregoing explanations.

Features that have already been described in connection with the analog-to-digital multi-bit delta-sigma modulator can readily also be applied to the method according to the invention, or to the ADC according to the invention - and vice versa.

It is additionally stated that terms, such as "comprising" or "employing" do not exclude further features or process steps. Furthermore it is mentioned that terms as "a" or "the", suggesting a single feature or a single step are not meant to exclude a plurality of such features or steps - and vice versa.

The subsequent description is described with reference to the accompanying figures.

The figures illustrate preferred embodiments in which individual features of the present invention are shown in combination with each other. However, features of an exemplary embodiment can also be implemented independently of the other features of the same embodiment and can readily be rearranged by the person skilled in the art to other advantageous combinations with features of other exemplary embodiments.

The use of the same reference numbers in different figures may, where feasible, indicates similar or identical items.

The figures show schematically:
- Fig. 1: a block diagram of a discrete-time main delta-sigma modulator for derivation of the main delta-sigma modulator according to the invention (part one);
- Fig. 2: a block diagram of a discrete-time main delta-sigma modulator for derivation of the main delta-sigma modulator according to the invention (part two);
- Fig. 3: a block diagram of a discrete-time main delta-sigma modulator according to the invention, with a two-stage multi-stage noise shaping delta-sigma modulator in its feedback path;
- Fig. 4: a block diagram of a discrete-time main delta-sigma modulator according to the invention, with a two-stage multi-stage noise shaping delta-sigma modulator in its feedback path and with both stages feeding into the outermost feedback branch of the loop filter;
- Fig. 5: a block diagram of a continuous-time main delta-sigma modulator according to the invention, with a two-stage multi-stage noise shaping delta-sigma modulator in its feedback path; and
- Fig. 6: a block diagram of a continuous-time main delta-sigma modulator according to the invention, with a two-stage multi-stage noise shaping delta-sigma modulator in its feedback path, together with a FIR feedback DAC.

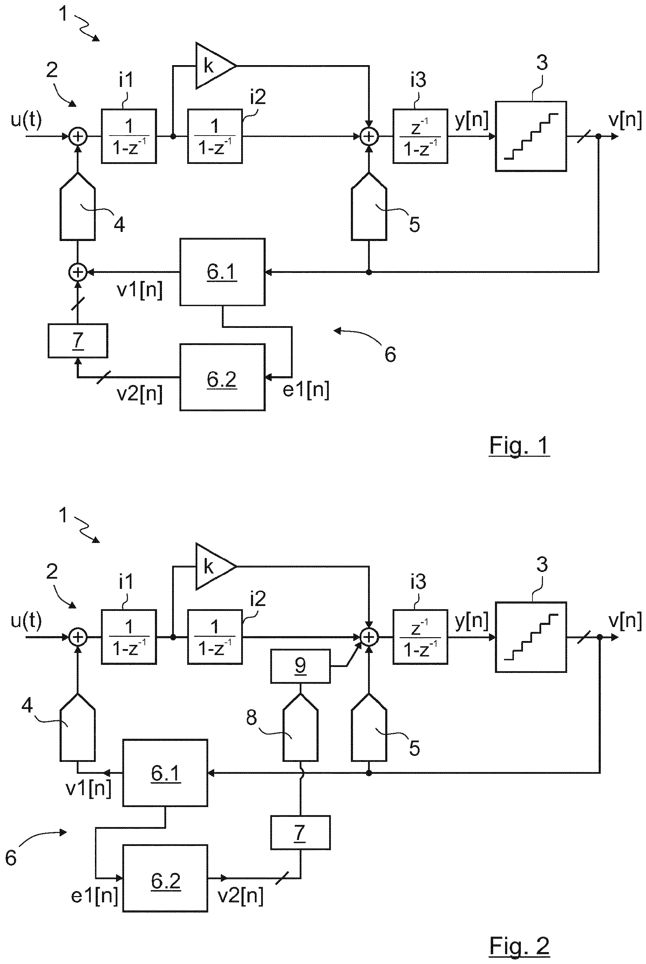

Figures 1-3 show the derivation of an exemplary implementation of an analog-to-digital multi-bit delta-sigma modulator 1 ("main DSM"), implemented as third order DT DSM with a mixed cascade of integrators feedback/feedforward compensation loop filter 2 and a multi-bit quantizer 3 quantizing the analog output y[n] of the loop filter 2 and generating a digital multi-bit output signal v[n].

As this exemplary loop filter architecture is a common architecture which is well-known in the state of the art, it will not be described in detail in the following. The person skilled in the art will anyhow be able to employ various loop filter orders and architectures together with the proposed invention. The exemplary architectures of the application examples are not meant to limit the invention to these specific embodiments.

The main DSM 1 also comprises at least one feedback DAC within the feedback path. In the application examples, two feedback DACs 4, 5 are employed: a first feedback DAC 4 feeding the outermost branch of the loop filter 2 (i. e., feeding a first integrator i1 closest to an input stage of the loop filter 2), and a second feedback DAC 5 feeding an inner node of the loop filter 2 (exemplarily the input node to the third integrator i3).

Within the feedback path, a digital-to-analog DSM is additionally provided, which is designed as MASH DSM 6. The exemplary MASH DSM 6 of the application examples consists of two stages 6.1, 6.2, wherein the first stage 6.1 uses a single-bit quantizer generating a first feedback signal component v1[n] of 1-bit and the second stage 6.2 comprises a multi-bit quantizer generating a second feedback signal component v2[n] of multi-bit fashion.

As MASH DSMs are also known, the two stages 6.1, 6.2 of the MASH DSM 6 are visualized as black boxes for simplicity reasons. The stages 6.1, 6.2 can exemplarily be implemented as second order digital DSM. As a matter of course, the person skilled in the art can again employ other orders of the first MASH stage 6.1 and/or the second MASH stage 6.2 (including 0^{th} order noise shaping), add more MASH stages, or decide on the word-lengths of the output signals, e. g., the digital feedback signal components v1[n], v2[n].

The noise shaping order of the MASH DSM 6 can be smaller, equal, or even higher than the noise shaping order of the loop filter 2 of the main DSM 1.

Importantly, the proposed invention allows to use a digital noise shaping DAC with a higher order than that of the main DSM 1 (in the example 2+2=4 versus 3) and with overall multi-bit quantization, which allows the additionally generated digital quantization noise to be sufficiently smaller than the original quantization noise of the main DSM 1.

Figure 1 shows the block diagram of main DSM 1 with the MASH DSM 6 already included in its feedback path. Using the shown architecture will limit the error injected into the loop filter 2 due to requantization to a value that is lower than the quantization error of the loop filter 2 of the main DSM 1. However, the overall MASH DSM 6 output is still multi-bit in nature due to the summation of the single-bit output of the first stage 6.1 (first feedback signal component v1[n]) with the filtered multi-bit output of the second stage 6.2 (second feedback signal component v2[n]), which contradicts the general idea of the invention to avoid a high-linearity multi-bit feedback DAC 4 in the outermost feedback branch.

In a conventional MASH DAC, the quantization noise e1[n] from the first stage is eliminated by the second stage in a subsequent cancellation filter. This cancellation filter is usually a low-pass filter of the order of the second stage of the MASH DAC subsequent to the first stage, and a high-pass filter of the order of the first stage of the MASH subsequent to the second stage. In the example as shown in Figure 1, the recombination is realized by a digital cancellation filter 7 replicating the noise transfer function (NTF) of the first MASH stage 6.1, following the second MASH stage 6.2. In general, the cancellation filter could also be a mixed-signal cancellation filter or an analog cancellation filter.

In the second derivation step as shown in Figure 2, the first feedback signal component v1[n] of the first stage 6.1 of the digital MASH DSM 6 is fed through the outermost feedback loop of the main DSM 1 resulting in a linear, single-bit first feedback DAC 4 at the most sensitive position of the main DSM 1. The second feedback signal component v2[n] (i. e., the multi-bit output of the second stage 6.2 of the digital MASH DSM 6) is fed to an internal node of the loop filter 2 of the main DSM 1 via an additional feedback DAC 8, wherein the nonlinearity of the additional multi-bit DAC 8 is of much lower concern, since it appears at an inner node of the main DSM, where errors are highly suppressed by the preceding loop filter stages.

In Figure 2, the output of the second MASH stage 6.2 is still followed by the cancellation filter 7 and fed into the inner node of the third integrator i3. An additional analog filter 9 is explicitly realized following the additional multi-bit DAC 8, because the part of the main DSM 1 loop filter 2, which is now bypassed by the additional DAC 8 (remember: in Figure 1, the second feedback signal component v2[n] was fed into the outermost branch), needs still to be implemented.

If the insertion node is correctly chosen as exemplarily shown in Figures 1-3, the bypassed part of the loop filter 2 of the main DSM 1 prior to this insertion point, which is low-pass in nature in this case, can be matched to the high-pass filter needed after the second MASH stage 6.2 (which equals the NTF of the first MASH stage 6.2). Then the loop filter 2 of the main DSM can implicitly act as recombination filter of the digital MASH DSM 6.

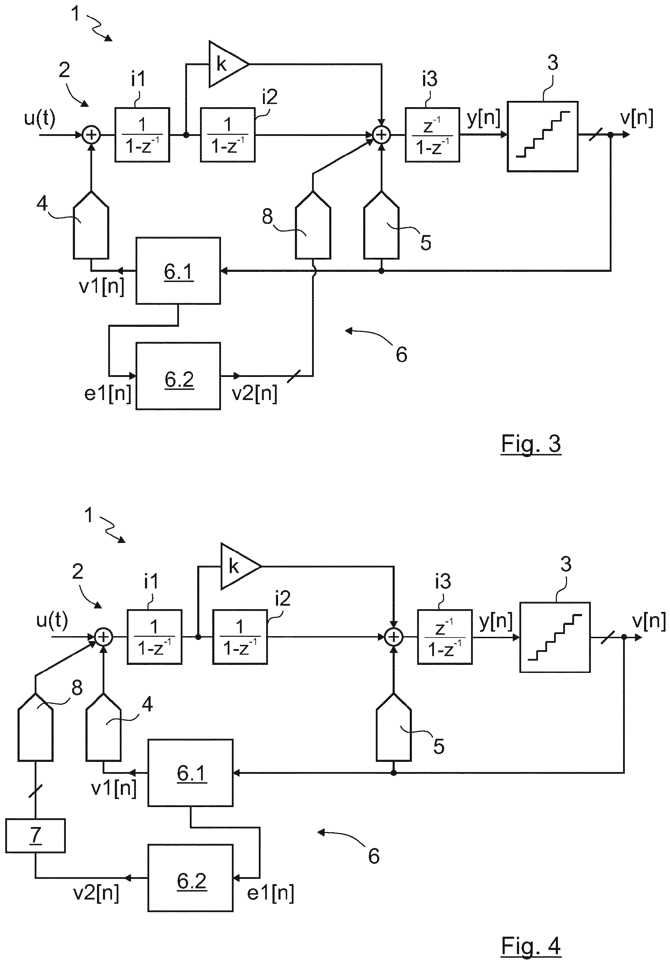

In the application example, the second MASH stage 6.2 generally needs to be followed by the exemplarily digital cancellation filter 7 (or by a mixed-signal or an analog cancellation filter). Assuming the loop filter of the main DSM 1 prior to the insertion point to be T1 and selecting the NTF of the first MASH stage 6.1 (and the digital cancellation filter 7) to 1/T1, the digital cancellation filter 7 and the additional analog filter 9 following the additional feedback DAC 8 cancel each other and the recombination filter for the second stage 6.2 of the MASH DSM 6 is implicitly realized by a part of the analog loop filter 2 of the main DSM 1. Thus, the black boxes 7, 9 can be combined to unity. This final architecture is shown in Figure 3. Note that although the cancellation filter is implicitly realized in this proposed architecture, it could also be realized partially explicit or completely explicit.

Thus, using a MASH DSM 6 with implicit cancellation filter can provide single-bit feedback in the outermost feedback DAC 4, while cancelling the single-bit quantization error by a multi-bit signal from the higher MASH stages, which in sum yields adding a negligibly small multi-bit quantization error into the main multi-bit DSM 1.

Figure 4 shows another possible embodiment of the invention with a different input node for the second feedback signal component v2[n] in the main loop filter 2. In this example, the second feedback signal component v2[n] is also fed back into the input node of the main DSM 1, together with the first feedback signal component v1[n] but via the additional feedback DAC 8. In this architecture, the additional feedback DAC 8 would still need some cancellation filter 7 upfront, which might be a digital, analog, or mixed-signal cancellation filter 7. However, the second stage 6.2 of the MASH DSM 6 of this example applies a single-bit quantization (but could also feature multi-bit quantization). The additional feedback DAC 8 is implemented as capacitor DAC, implicitly realizing a first order high-pass filter, which can act as a part of the necessary cancellation logic for the recombination of the two MASH stages 6.1, 6.2. Thus, the cancellation filter 7 upfront DAC 8 can also be merged with DAC 8 in order to realize the recombination logic.

Although through the addition of both single-bit feedback signal components v1[n], v2[n] in the input node of the main DSM 1 the overall feedback signal is of multi-bit nature again, nonlinearity would still be of lesser concern as a mismatch between the additional feedback DAC 8 and the first feedback DAC 4 would result in a mismatch of the MASH stages 6.1, 6.2 - but not in a nonlinearity error. The mismatch of the MASH stages 6.1, 6.2 could readily be corrected for.

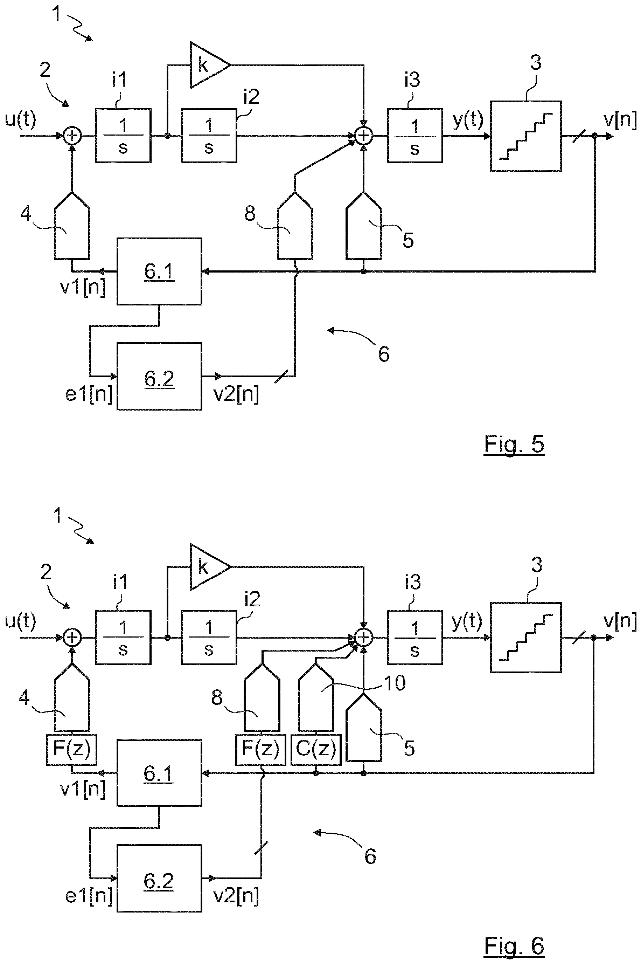

Figure 5 shows an extension of the presented invention for usage in a CT DSM 1.

If the loop filter 2 of the main DSM 1 is realized with CT filters - as usually done for high speed applications - the combination of the digital transfer function (digital cancellation filter 7) and the analog integrators i1, i2, i3 of the main loop filter 2 (c. f. T1) into unity is no longer exactly correct. This is because the digital transfer function is periodic with the sampling frequency, whereas the analog transfer function T1 of the CT loop filter is not. Thus, especially at larger frequencies, the matching fails, and the transfer functions in the black boxes 7, 9 in Figure 2 do not cancel to unity - at least not exactly.

Therefore, in order to have the recombination filter again being approximately, implicitly and sufficiently correct realized by the preceding main DSM 1 loop filter 2, the digital part of the circuit can be slightly oversampled (e. g. by a factor of two), which makes the cancellation again approximately valid.

Figure 6 shows another aspect of the invention employing a FIR feedback DAC in a CT DSM 1. Therefore, the output of the outermost feedback, which in the presented invention is the MASH DSM 6, can be followed by a mixed-signal FIR-filter F(z). Another filter, C(z) is needed at an inner loop for the restauration of the original NTF of the main DSM 1, exemplarily realized by the compensation FIR DAC 10 in Figure 6.

In one embodiment of the present invention, only the first feedback signal component v1[n] with 1- or 1.5-bitwidth can be fed into the outermost loop for superior linearity. This causes worse jitter sensitivity in comparison to the original multi-bit feedback signal; a FIR-filter F(z) improves the jitter insensitivity. The second feedback signal component v2[n] can be fed into a later input node, where it is also filtered by the same FIR-filter F(z). This is done since the second feedback signal component v2[n], i. e., the multi-bit MASH output, is supposed to eliminate the quantization noise of the first feedback signal component v1[n], so the two paths need matching, for which the same FIR-filter F(z) is employed.

## Claims

1. An analog-to-digital multi-bit delta-sigma modulator (1) comprising a loop filter (2) with a feedback path, a multi-bit quantizer (3) quantizing the output (y[n], y(t)) of the loop filter (2) and generating a digital multi-bit output signal (v[n]), and at least one feedback digital-to-analog converter (4, 5) within the feedback path, wherein a digital-to-analog delta-sigma modulator (6) is additionally provided within the feedback path generating a first feedback signal component (v1[n]) by reducing the word-length of the digital multi-bit output signal (v[n]), wherein the first feedback signal component (v1[n]) is fed into the outermost branch of the loop filter (2) via the at least one feedback digital-to-analog converter (4),
**characterized in that**
the digital-to-analog delta-sigma modulator (6) is designed as multi-stage noise shaping delta-sigma modulator (6) comprising a first stage (6.1) for generating the first feedback signal component (v1[n]), and at least a second stage (6.2) for generating at least one additional feedback signal component (v2[n]), wherein the at least one additional feedback signal component (v2[n]) is also fed into the loop filter (2), and wherein the node for feeding-in the at least one additional feedback signal component (v2[n]) is chosen such and the loop filter (2) is designed such that a combination filter for the feedback signal components (v1[n], v2[n]) of the multi-stage noise shaping delta-sigma modulator stages (6.1, 6.2) is realized.

2. An analog-to-digital multi-bit delta-sigma modulator (1) according to claim 1,
**characterized in that**
the combination filter for the feedback signal components (v1[n], v2[n]) is realized as purely implicit, partly implicit or explicit combination filter.

3. An analog-to-digital multi-bit delta-sigma modulator (1) according to claim 1 or 2,
**characterized in that**
the outermost branch is a branch feeding a first integrator (i1) closest to an input stage of the loop filter (2).

4. An analog-to-digital multi-bit delta-sigma modulator (1) according to one of the claims 1 to 3,
**characterized in that**
the at least one additional feedback signal component (v2[n]) is fed into an inner node of the loop filter, i. e., a node preceding an integrator (i1, i2, i3) or the quantizer (3), via an additional feedback digital-to-analog converter (8).

5. An analog-to-digital multi-bit delta-sigma modulator (1) according to one of the claims 1 to 3,
**characterized in that**
the at least one additional feedback signal component (v2[n]) is fed into the same node as the first feedback signal component (v1[n]), via an additional filtering feedback digital-to-analog converter (8).

6. An analog-to-digital multi-bit delta-sigma modulator (1) according to one of the claims 1 to 5,
**characterized in that**
the feedback digital-to-analog converter (4) feeding the outermost branch and/or the additional filtering feedback digital-to-analog converter (8) is designed as single-bit digital-to-analog converter.

7. An analog-to-digital multi-bit delta-sigma modulator (1) according to one of the claims 1 to 6,
**characterized in that**
the word-length of the first feedback signal component (v1[n]) is less than the word-length of the at least one additional feedback signal component (v2[n]).

8. An analog-to-digital multi-bit delta-sigma modulator (1) according to one of the claims 1 to 7,
**characterized in that**
the first feedback signal component (v1[n]) consists of a word-length of one or 1.5-bit.

9. An analog-to-digital multi-bit delta-sigma modulator (1) according to one of the claims 1 to 8,
**characterized in that**
the multi-stage noise shaping delta-sigma modulator (6) consists of two stages (6.1, 6.2), wherein the second stage (6.2) comprises a single-bit or multi-bit quantizer.

10. An analog-to-digital multi-bit delta-sigma modulator (1) according to one of the claims 1 to 9,
**characterized in that**
the noise shaping order of the multi-stage noise shaping delta-sigma modulator (6) is lower, equal or higher than the noise shaping order of the loop filter (2) of the analog-to-digital multi-bit delta-sigma modulator (1).

11. An analog-to-digital multi-bit delta-sigma modulator (1) according to one of the claims 1 to 10,
**characterized in that**
the loop filter (2) is implemented as continuous-time, discrete-time or hybrid loop filter.

12. An analog-to-digital multi-bit delta-sigma modulator (1) according to one of the claims 1 to 11,
**characterized in that**
the feedback signal components (v1[n], v2[n]) of the multi-stage noise shaping delta-sigma modulator (6) are injected into the loop filter (2) using at least one mixed-signal finite impulse response feedback digital-to-analog converter.

13. A method for converting an analog input signal (u(t)) into a digital multi-bit output signal (v[n]) employing an analog-to-digital multi-bit delta-sigma modulator (1) comprising a loop filter (2) with a feedback path, a multi-bit quantizer (3), and at least one feedback digital-to-analog converter (4, 5) within the feedback path, wherein the quantizer (3) quantizes the output (y[n], y(t)) of the loop filter (2) and generates the digital multi-bit output signal (v[n]), wherein a digital-to-analog delta-sigma modulator (6) is additionally employed within the feedback path which generates a first feedback signal component (v1[n]) by reducing the word-length of the digital multi-bit output signal (v[n]), whereby the first feedback signal component (v1[n]) is fed into the outermost branch of the loop filter (2) via the at least one feedback digital-to-analog converter (4),
**characterized in that**
the digital-to-analog delta-sigma modulator (6) is designed as multi-stage noise shaping delta-sigma modulator (6) comprising a first stage (6.1) generating the first feedback signal component (v1[n]), and a at least a second stage (6.2) generating at least one additional feedback signal component (v2[n]), wherein the at least one additional feedback signal component (v2[n]) is also fed into the loop filter (2), and wherein the node for feeding-in the at least one additional feedback signal component (v2[n]) is chosen such and the loop filter (2) is designed such that a combination filter for the feedback signal components (v1[n], v2[n]) of the multi-stage noise shaping delta-sigma modulator stages (6.1, 6.2) is realized.

14. A method according to claim 13,
**characterized in that**
the multi-stage noise shaping delta-sigma modulator (6) is operated at a higher sampling frequency than the analog-to-digital multi-bit delta-sigma modulator (1), preferably at two times the sampling frequency of the analog-to-digital multi-bit delta-sigma modulator (1).

15. An analog-to-digital converter employing an analog-to-digital multi-bit delta-sigma modulator (1) according to one of the claims 1 to 12.
